(19) Europäisches Patentamt
European Patent Office
Office européen des brevets

(11) Publication number: **0 068 599**
**B1**

(12) **EUROPEAN PATENT SPECIFICATION**

(45) Date of publication of patent specification: **13.02.85**

(51) Int. Cl.⁴: **G 03 F 7/02,** G 03 C 1/68

(21) Application number: **82301000.4**

(22) Date of filing: **26.02.82**

(54) **Photo-sensitive resin material.**

(30) Priority: **18.06.81 JP 94892/81**

(43) Date of publication of application:
**05.01.83 Bulletin 83/01**

(45) Publication of the grant of the patent:
**13.02.85 Bulletin 85/07**

(84) Designated Contracting States:
**DE FR GB IT**

(56) References cited:
**DE-A-2 631 837**
**US-A-4 072 527**
**US-A-4 262 079**
**US-A-4 268 611**

(73) Proprietor: **Nippon Paint Company, Ltd**
**2-1-2, Oyodokita Oyodo-ku**
**Osaka-shi Osaka-fu (JP)**

(72) Inventor: **Kusuda, Hidefumi**
**Nippon Paint Co. Ltd. No. 19-17 Ikedanaka-machi**
**Neyagawa Osaka (JP)**

(74) Representative: **Perry, Robert Edward et al**
**GILL JENNINGS & EVERY 53-64 Chancery Lane**
**London WC2A 1HN (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**EP 0 068 599 B1**

**Description**

The present invention relates to a photo-sensitive resin material. More particularly, it relates to a photosensitive resin material which is intended not to adhere to an original, which allows easy positioning of the original thereon, and which protects itself and the original from damage.

In general, a photo-sensitive resin material is exposed to light when in close contact with an original. When the surface of the photo-sensitive resin material to be brought into contact with an original is tacky, the original is usually positioned thereon under reduced pressure, after application of a fine powder such as french powder or talc, so as to counteract the tackiness. Alternatively, an original may be brought into contact with the photo-sensitive resin material gradually, from its edge, a rubber roller, say, then being used to expel air between them. These conventional procedures for ensuring close contact take considerable time. Further, the surfaces of the photo-sensitive resin material and of the original are often damaged as a result of the tackiness.

Japanese Patent Publication No. 125805/1975 (corresponding to US—A—4 268 611) discloses a resin layer comprising a mat agent such as silica gel on the surface of a photo-sensitive resin material. The intention is to facilitate the positioning of an original but this proposal is not sufficiently effective when the tackiness of the photo-sensitive resin material is considerable.

According to the present invention, a photo-sensitive resin material comprises in order a photo-sensitive resin layer, a light-permeable protective film layer, attached to the resin layer which protective film layer is non-tacky and soluble in, or swellable with, water or an alcohol, a release layer and a sheet material, the protective film layer remaining attached to the photo-sensitive resin layer on removal of the sheet material.

A photo-sensitive resin material according to the invention often includes a backing material attached to the surface of the photo-sensitive resin layer opposite from that surface attached to the light-permeable protective film layer. A photo-sensitive material of the invention including a backing material is illustrated in the accompanying drawing. The drawing shows a photo-sensitive resin layer (1), to one surface of which a backing material (2) is attached. A protective film layer (3) is attached to the other surface of the photo-sensitive resin layer (1). The protective film layer (3) is attached to a sheet material (4) with an intervening release layer (5).

The photo-sensitive resin layer is usually tacky at the surface. It can usually be developed with a water or alcohol-containing organic solvent. It may be made of a photo-sensitive resin composition comprising a polymeric binder (e.g. crystalline 1,2-polybutadiene, styrene-butadiene-styrene copolymer, styreneisoprene-styrene copolymer, nitrile-butadiene resin, water or alcohol-soluble polyamide resin, polyvinyl alcohol, cellulose acetate succinate, cellulose acetate phthalate), an addition polymerizable unsaturated monomer (e.g. 2-ethylhexyl acrylate, 2-ethylhexyl methacrylate, octyl acrylate, octyl methacrylate, lauryl acrylate, lauryl methacrylate, stearyl acrylate, stearyl methacrylate, trimethylolpropane triacrylate, trimethylolpropane trimethacrylate, trimethylolethane triacrylate, trimethylolethane trimethacrylate, ethylene glycol acrylate, ethylene glycol methacrylate, triethylene glycol diacrylate, triethylene glycol dimethacrylate, β-hydroxyethyl acrylate, β-hydroxyethyl methacrylate, β-hydroxypropyl acrylate, β-hydroxypropyl methacrylate, acrylamide, methacrylamide, N,N'-methylenebisacrylamide) and an addition polymerization initiator (e.g. benzoin alkyl ether, benzoin, benzylanthraquinone, 2-methylanthraquinone, 2-t-butylanthraquinone, p-dinitrobenzene, 2-chloro-4-nitroaniline, 9-nathranylaldehyde, benzophenone, 1,2-naphthoquinone, 4-naphthoquinone) optionally with any additive(s) such as a thermal polymerization inhibitor (e.g. hydroquinone, p-methoxyphenol, t-butylcatechol, 2,6-di-t-butyl-p-cresol), a dyestuff or a pigment. The above photosensitive resin composition, particularly containing 1,2-polybutadiene, is suitable, for instance, for preparation of a printing plate for flexography (cf. German Offenlegungsschrift No. 26 31 837), i.e. an off-set process, the printing plate exhibiting a flexibility like rubber.

Usually, the photosensitive resin layer is supported on a backing material, for instance, made of a plastic material (e.g. polyester, polycarbonate, polyacrylate, polypropylene). Such supporting may be effected simultaneously or after the molding of the photosensitive resin layer.

For development of such photosensitive resin composition, there may be used any solvent system comprising as the major solvent a chlorinated hydrocarbon (e.g. perchloroethylene, trichloroethylene, 1,1,1-trichloroethane, carbon tetrachloride), an aromatic hydrocarbon (e.g. toluene, xylene), a ketone (e.g. methyl ethyl ketone, methyl isobutyl ketone), a cellosolve acetate or the like and as the controlling agent water or an alcohol (e.g. methanol, ethanol, isopropanol, n-butanol).

The protective film layer is required to be light-permeable and may be transparent or semi-transparent. It is also required to be soluble in or swellable with water or an alcohol to be used on development of the photosensitive resin composition. Such layer may be made of a film-forming material such as methylcellulose (e.g. "Methorose" manufactured by Shinetsu Chemical Co., Ltc., "Ethocel" manufactured by Dow Chemical Co., Ltd.), water or alcohol-soluble polyamide (e.g. "Soluble Polyamide CM4000" or "Soluble Polyamide CM8000" manufactured by Toray Co., Ltd.) or polyvinyl alcohol (e.g. "KH—20" or "KH—17" manufactured by Nippon Gosei Kagaku K.K.), butyral (e.g. "Ethrec" manufactured by Sekisui Chemical Co., Ltd.), these film-forming materials can give a film of good lubricity.

For formation of the protective film layer, a solution of the film-forming material as exemplified above in an alcohol or its mixture with water, for instance, at a concentration of 1 to 10% by weight (based on the

solution) may be applied onto the surface of a sheet material, for instance, made of any plastic material (e.g. polyester, polycarbonate, polyacrylate, polypropylene), the said surface being preferably roughened by chemical etching or physical polishing. The thickness of the protective film layer is preferred to be from about 0.5 to 10 µm.

In order to ensure the separation of the sheet material from the protective film layer on the elimination of the sheet material, a releasing layer should be provided between the sheet material and the protective film layer. Thus, the said roughened surface of the sheet material may be treated with a silicone resin, followed by drying to make a releasing layer of about 0.1 to 0.5 µm in thickness, and then the said application of the solution of the film-forming material may be effected. When the releasing layer is not provided, the complete and easy separation of the protective film layer from the sheet material is difficult even if the photosensitive resin layer has a great tackiness.

As the silicone resin, there are known two types of resins, i.e. (A) the addition curing type resin having the formula:

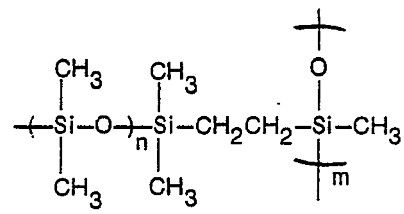

and (B) the condensation curing type resin having the formula:

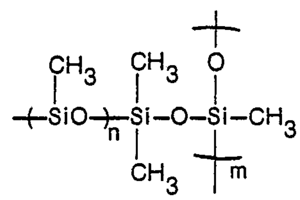

Examples of the commercially available silicone resins are Toray silicone paper coating agents of addition type "SD7226" (catalyst "SRX212") and of condensation type "SRX244" (catalyst "SRX242AC").

For preparation of the photosensitive resin material of the invention, the photosensitive resin layer and the protective film layer may be combined together. Usually, the photosensitive resin layer, with or without a backing material, and the protective film layer provided on a sheet material with intervention of a releasing layer are brought into close contact by a conventional combination procedure such as heat pressing, laminating or extrusion molding to make a photosensitive resin material.

Continuous production by supplying the photo-sensitive resin layer immediately after extrusion molding onto the protective film layer as previously manufactured is favorable from the industrial viewpoint. When the surface of the protective film layer is roughened by the influence of the roughened surface of the sheet material on which the protective film layer is provided with intervention of the releasing layer, take-up of the extruded photosensitive resin layer onto the protective film layer can be accomplished smoothly.

On use of the photosensitive resin material, the sheet material attached to the protective film layer with intervention of the releasing layer is eliminated so that the protective film layer remains on the surface of the photosensitive resin layer. The, an original is placed on the protective film layer and exposed to light for a desired time. Treatment of the exposed surface with a water or alcohol-containing organic solvent, preferably while brushing, accomplishes development and affords a printing plate having an excellent relief exactly copying the image in the original.

Since the photosensitive resin material of the invention has the protective film layer on the surfece of the photosensitive resin layer, the tackiness of the photosensitive resin layer does not cause any problem. Further, the favorable lubricity of the protective film layer facilitates bringing an original into close contact with the surface of the photosensitive resin layer. Besides, the protective film layer is readily eliminated on treatment with a water or alcohol-containing organic solvent for development and therefore does not afford any unfavorable influence on the printing characteristics of the printing plate obtained from the photosensitive resin material.

The present invention will be illustrated in the Examples, by contrast with Comparative Examples.

Example 1

On a sheet material having a chemically etched surface (polyester film — 100 µm in thickness and 3.0 µm in average roughness), a silicone resin ("Toray silicone SRX244", solvent type; using "SRX242AC" as the catalyst) was applied by the aid of a doctor blade to make a releasing layer — 0.5 µm in thickness. After

being allowed to stand at room temperature for 24 hours, a 1.8% by weight solution of methylcellulose ("60SH4000" and "60SH400" manufactured by Shinetsu Chemical Co., Ltd.) in a mixture of methanol and water was applied onto the releasing layer by the aid of a bar coater to make a protective film layer — 1.5 μm in thickness.

Onto one surface of a photosensitive resin layer comprising crystalline 1,2-polybutadiene as a polymeric binder, a polyester sheet as a backing material was provided. After heating in a hot wind drying furnace at 80°C for 2 minutes, the above-prepared protective film layer was brought into contact with the other surface of the photosensitive resin layer, to combine them. The resulting layered product was placed on a cooling plate at 16°C for 10 minutes to give a photosensitive resin material having a photosensitive resin layer of which the surface was protected.

Explaining the construction of the thus-obtained photosensitive resin material with reference to the accompanying drawing, the photosensitive resin layer (1) is provided with the backing material (2) at one surface. Onto the other surface of the photosensitive resin layer (1), the protective film layer (3) is present. The protective film layer (3) is attached to the sheet material (4) with intervention of the releasing layer (5).

Removing the sheet material from the photosensitive resin material, there was obtained a photosensitive resin sheet having a photosensitive resin layer of which the surface was covered by a protective film layer (non-tacky methylcellulose film of 1.5 μm in thickness and 2.4 μ in roughness ($R_{max}$)).

An original was placed on the protective film layer of the photosensitive resin sheet. This placement was accomplished easily, and the original was retained at a good contact state. An ultra-violet lamp was used to irradiate the photosensitive resin sheet through the original for 10 minutes, and the original was taken off. This taking off was made readily without damaging the original or the photosensitive resin sheet.

The thus-exposed sheet was washed with a mixture of isopropanol and 1,1,1-trichloroethane (1:3 by volume) under brushing for development and dried in a drying furnace at 50°C for 20 minutes to give a printing plate having a relief exactly copying the image in the original. The shoulder shape of the relief image was excellent.

Comparative Example 1

Onto the photosensitive resin layer as in Example 1, the sheet material as in Example 1 (having a chemically etched surface) was brought into contact by pressing. Thus, the sheet material did not have the releasing layer or the protective film layer.

After removal of the sheet material, an original was placed on the photosensitive resin layer. Due to the tackiness of the photosensitive resin layer, the placement of the original was somewhat difficult. In addition, close contact between the photosensitive resin layer and the original required the use of a rubber roller.

Comparative Example 2

Onto the photosensitive resin layer as in Example 1, the sheet material as in Example 1 (not having a chemically etched surface) was brought into contact by pressing. Thus, the sheet material did not have the releasing layer or the protective film layer.

After removal of the sheet material, an original was placed on the photosensitive resin layer. Due to the tackiness of the photosensitive resin layer, the placement of the original was difficult. In addition, the original was damaged when taken off after exposure.

Example 2

A sheet material having a chemically etched surface (polyester film — 100 μm in thickness and 2.4 μm in average roughness) was subjected to antistatic treatment, and a silicone resin as in Example 1 was applied thereon by the aid of a gravure coater to make a releasing layer of 0.4 μm in thickness. After allowing it to stand at room temperature for 2 days, a 2.2% by weight solution of a mixture of two kinds of methylcellulose ((a) heat gelling temperature, 60°C; molecular weight, 4,000; (b) heat gelling temperature, 65°C, molecular weight, 400) in a mixture of methanol and water was applied onto the releasing layer using a reverse coater to make a protective film layer — 1.5 μm in thickness. After drying, the layered product was rolled up.

A photosensitive resin composition comprising crystalline 1,2-polybutadiene (crystallinity, 13%; average molecular weight, 100,000) as a polymeric binder was extruded through a T-die continuously to make a photosensitive resin layer in a melt state at 100°C, which was taken up on the protective film layer of the above-obtained layered product. The resultant layered product was then attached onto a polyester sheet as a backing material at the opposite surface, followed by cutting to obtain a photosensitive resin material.

The photosensitive resin material could be used in the same manner as in Example 1, with excellent performances.

Comparative Example 3

The photosensitive resin composition as in Example 2 was extruded through a T-die continuously to make a photosensitive resin layer in a melt state at 100°C, which was taken up on the layered product as in Example 2 except that the sheet material was not chemically etched at the surface and a releasing layer was

not provided between the sheet material and the protective film layer.

Taking up of the photosensitive resin layer could not be effected smoothly. Further retention of the protective film layer on the photosensitive resin layer when the sheet material was taken off was not perfect.

## Claims

1. A photo-sensitive resin material which comprises, in order, a photo-sensitive resin layer (1), a light-permeable protective film layer (3), attached to the resin layer (1), which protective film layer is non-tacky and soluble in, or swellable with, water or an alcohol; a release layer (5); and a sheet material (4), the protective film layer (3) remaining attached to the photo-sensitive resin layer (1) on removal of the sheet material (4).

2. A photo-sensitive resin material which comprises, in order, a backing material (2); a photo-sensitive resin layer (1); a light-permeable protective film layer (3), attached to the resin layer (1), which protective film layer is non-tacky and soluble in, or swellable with, water or an alcohol; a release layer (5); and a sheet material (4), the protective film layer (3) remaining attached to the photo-sensitive resin layer (1) on removal of the sheet material (4).

3. A resin material according to claim 1 or claim 2, wherein the sheet material (4) has a surface roughness of from 0.1 to 5.0 µm.

4. A resin material according to any preceding claim, wherein the release layer (5) has a thickness of from 0.1 to 0.5 µm.

5. A resin material according to any preceding claim, wherein the protective film layer (3) has a thickness of from 0.5 to 10 µm.

6. A printing plate for flexography, which comprises a resin material according to any preceding claim.

## Revendications

1. Un matériau de résine photosensible qui comprend, dans l'ordre, une couche de résine photosensible (1), un film protecteur perméable à la lumière (3), fixé sur la couche de résine (1), ledit film protecteur étant non collant et soluble ou gonflable dans l'eau ou un alcool; une couche de séparation (5); et une matière en feuille (4), le film protecteur (3) restant fixé à la couche de résine photosensible (1) lors de l'enlèvement de la matière en feuille (4).

2. Un matériau de résine photosensible qui comprend, dans l'ordre, une matière de support (2); une couche de résine photosensible (1); un film protecteur perméable à la lumière (3), fixé sur la couche de résine (1), ledit film protecteur étant non collant et soluble ou gonflable dans l'eau ou un alcool; une couche de séparation (5); et une matière en feuille (4), le film protecteur (3) restant fixé à la couche de résine photosensible (1) lors de l'enlèvement de la matière en feuille (4).

3. Un matériau de résine selon la revendication 1 ou la revendication 2, dans lequel la matière en feuille (4) a une rugosité de surface de 0,1 à 5,0 µm.

4. Un matériau de résine selon l'une quelconque des revendications précédentes, dans lequel la couche de séparation (5) a une épaisseur de 0,1 à 0,5 µm.

5. Un matériau de résine selon l'une quelconque des revendications précédentes, dans lequel le film protecteur (3) a une épaisseur de 0,5 à 10 µm.

6. Une plaque d'impression pour flexographie, qui comprend un matériau de résine selon l'une quelconque des revendications précédentes.

## Patentansprüche

1. Lichtempfindliches Harz-Material, umfassend, in dieser Reihenfolge, eine Schicht aus lichtempfindlichem Harz (1), eine lichtdurchlässige Schicht einer Schutzfolie (3), befestigt an der Harz-Schicht (1), wobei diese Schutzfolien-Schicht nicht klebrig und löslich in oder quellbar mit Wasser oder einem Alkohol ist, eine Antihaftschicht (5) und eine Folienmaterial (4), wobei die Schutzfolien-Schicht (3) beim Entfernen des Folienmaterials (4) an der Schicht aus dem lichtempfindlichen Harz (1) haftend verbleibt.

2. Lichtempfindliches Harz-Material, umfassend, in dieser Reihenfolge, ein Kaschierungsmaterial (2), eine Schicht aus lichtempfindlichem Harz (1), eine lichtdurchlässige Schicht einer Schutzfolie (3), befestigt an der Harz-Schicht (1), wobei diese Schutzfolien-Schicht nicht klebrig und löslich in oder quellbar mit Wasser oder einem Alkohol ist, eine Antihaftschicht (5) und ein Folienmaterial (4), wobei die Schutzfolien-Schicht (3) beim Entfernen des Folienmaterials (4) an der Schicht aus dem lichtempfindlichen Harz (1) haftend verbleibt.

3. Harz-Material nach Anspruch 1 oder Anspruch 2, dadurch gekennzeichnet, daß das Folienmaterial (4) eine Oberflächenrauhigkeit von 0,1 bis 5,0 µm besitzt.

4. Harz-Material nach irgendeinem der vorhergehenden Ansprüche, dadurch gekennzeichnet, daß die Antihaftschicht (5) eine Dicke von 0,1 bis 0,5 µm besitzt.

5. Harz-Material nach irgendeinem der vorhergehenden Ansprüche, dadurch gekennzeichnet, daß die Schutzfolien-Schicht (5) eine Dicke von 0,5 bis 10 µm besitzt.

6. Druckplatte für die Flexographie, enthaltend ein Harz-Material nach irgendeinem der vorhergehenden Ansprüche.

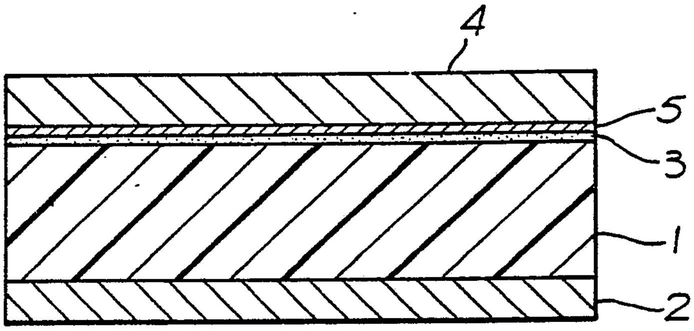
4
5
3
1
2